Europäisches Patentamt

European Patent Office

Office européen des brevets

(11) Numéro de publication : **0 087 159**
**B1**

# FASCICULE DE BREVET EUROPÉEN

(45) Date de publication du fascicule du brevet :
06.05.87

(51) Int. Cl.⁴ : **H 01 L 25/16**

(21) Numéro de dépôt : **83101680.3**

(22) Date de dépôt : **22.02.83**

(54) **Traversée électrique de boîtier de circuit hybride et connecteurs complementaires.**

(30) Priorité : **24.02.82 FR 8203035**

(43) Date de publication de la demande :
**31.08.83 Bulletin 83/35**

(45) Mention de la délivrance du brevet :
**06.05.87 Bulletin 87/19**

(84) Etats contractants désignés :
**CH DE FR GB IT LI SE**

(56) Documents cités :
**EP-A- 0 001 892**
**EP-A- 0 038 578**
**DE-A- 2 652 262**
**DE-B- 1 151 582**
**FR-A- 1 543 300**
**FR-A- 2 069 787**
**US-A- 3 614 706**
**ELECTRONICS, vol. 46, no. 12, 7 juin 1973, pages 89-104, New York, USA L. ALTMAN: "Hybrid technology solves tough design problems"**

(73) Titulaire : **CIMSA SINTRA**
**26, rue Malakoff**
**F-92600 Asnieres (FR)**

(72) Inventeur : **Bauchet, Bernard**
**19, avenue A. Le Petit**
**F-95530 La Frette (FR)**

(74) Mandataire : **Lincot, Georges et al**
**THOMSON-CSF SCPI 19, avenue de Messine**
**F-75008 Paris (FR)**

## Description

La présente invention porte sur les connexions entre circuits hybrides montés en boîtier métallique hermétique et des circuits extérieurs, réalisées au moyen de traversées électriques scellées et isolées électriquement dans l'épaisseur du boîtier en particulier au moyen de perles de verre individuelles pour l'obtention de l'herméticité du boîtier à leur niveau. Elle porte sur de telles traversées électriques permettant à volonté des connexions directes et permanentes et/ou des connexions amovibles par connecteurs ; elle porte donc, en conséquence, également sur des connecteurs complémentaires qui, montés sur une série de ces traversées, viennent assurer ces connexions amovibles sur les traversées, c'est-à-dire entre les circuits extérieurs et les circuits hybrides internes au boîtier.

Dans le domaine de la microélectronique les traversées électriques de boîtiers métalliques hermétiques renfermant des circuits hybrides se présentent, de manière courante, sous forme de petites tiges cylindriques scellées dans l'épaisseur du boîtier au moyen de perles de verre. Ces tiges débordent intérieurement dans le boîtier pour leur raccordement au circuit hybride interne et débordent aussi extérieurement au boîtier pour leur raccordement à des circuits extérieurs. Selon que les extrémités de ces tiges, extérieures au boîtier sont courtes ou non, on adopte pour ces connexions externes un raccordement par l'intermédiaire d'un connecteur complémentaire ou un raccordement fixe individuel pour chaque traversée par enroulement et soudure sur l'extrémité de la tige, alors relativement longue, d'un conducteur relié au circuit extérieur.

Ces traversées, à extrémités extérieures courtes, ont l'avantage de présenter un encombrement minimal, cependant elles interdisent une connexion fixe par soudure ; celles à extrémités extérieures longues augmentent les dimensions extérieures du boîtier résultant, de plus le montage et le démontage de la connexion par soudure doivent être réalisés avec de grandes précautions pour éviter une mise en court-circuit de la traversée sur le boîtier ou entre traversées, par surépaisseur de soudure, ou des dégradations inacceptables de l'état physique des traversées.

Une augmentation de diamètre de la broche dans la partie qui est extérieure au boîtier permettrait, à la manière de ce qui est pratiqué, par exemple pour les connecteurs de câbles coaxiaux ou sur certaines fiches « bananes », de réaliser des traversées électriques de boîtier de circuit hybride adaptées aussi bien à un mode de raccordement fixe, par soudure, qu'à un mode de raccordement amovible, par connecteur complémentaire, sur un circuit extérieur.

Cependant, la remontée du verre par capilarité, en cours de fabrication, jusqu'à la partie de plus fort diamètre de la broche fragilise ce type de réalisation au point d'occasionner des fissures dans les perles de verre lorsque des contraintes mécaniques sont exercées sur les broches au moment notamment de l'enfichage de connecteurs sur celles-ci ce qui rompt l'étanchéité des boîtiers.

Le but de l'invention est de pallier les inconvénients précités.

A cet effet, l'invention a pour objet, une traversée électrique de boîtier de circuit hybride, ayant la forme générale d'une broche cylindrique, montée fixée dans l'épaisseur du boîtier en ayant ses extrémités débordant intérieurement et extérieurement, pour sa connexion au circuit hybride et à un circuit extérieur, respectivement, caractérisée en ce que l'extrémité de ladite traversée, externe au boîtier, comporte une tête terminale cylindrique distante de la paroi du boîtier, de diamètre supérieur à celui du corps de la traversée et pourvue d'un canal intérieur axial, de manière à y permettre à volonté le raccordement par soudure d'un conducteur extérieur ou le raccordement de l'une des broches conductrices d'un connecteur.

Elle a également pour objet l'association des traversées ainsi obtenues à des connecteurs extérieurs complémentaires.

L'invention a principalement pour avantage qu'elle permet à volonté un câblage direct en autorisant l'engagement d'un conducteur étamé dans la tête terminale et la soudure classique à l'étain-plomb de ce conducteur ou, en variante, une connexion amovible au moyen d'un connecteur complémentaire, du fait essentiellement de la présence de l'épaulement défini, à l'extérieur du boîtier et à distance de sa paroi, par la tête terminale sur le corps de cette traversée.

Elle permet également des montages et démontages aisés des connecteurs pouvant être effectués fréquemment, assurant des connexions fiables même dans des conditions de vibrations de manière à permettre leur utilisation temporaire ou permanente.

L'invention sera décrite ci-après plus en détail à l'aide de plusieurs exemples de réalisation illustrés dans les dessins ci-annexés. Dans ces dessins :

la figure 1 illustre en perspective un boîtier de circuit hybride équipé de traversées électriques adaptées à une soudure directe de conducteurs, selon l'invention,

la figure 2 illustre en perspective le boîtier précédent équipé des mêmes traversées électriques auxquelles sont associés deux connecteurs complémentaires conformes à l'invention,

les figures 3 et 4 illustrent deux variantes des connecteurs précédents, assurant la mise à terre de toutes ces traversées,

la figure 5 est une coupe effectuée selon la ligne V-V de la figure 2, illustrant les traversées électriques conformes à l'invention,

la figure 6 est une coupe selon la ligne VI-VI de la figure 2, illustrant l'un des connecteurs complémentaires selon l'invention,

la figure 7 est une coupe selon la ligne VII-VII de la figure 2 illustrant l'autre des connecteurs complémentaires selon l'invention,

la figure 8 est une vue en coupe du connecteur de la figure 7, effectuée selon la ligne VIII-VIII de cette figure 7,

la figure 9 est une vue en coupe du connecteur de la figure 3, effectuée selon la ligne IX-IX de cette figure 3,

la figure 10 est une autre vue en coupe du connecteur de la figure 3, effectuée selon la ligne X-X de la figure 9,

la figure 11 est une vue en coupe du connecteur de la figure 4, effectuée selon ligne XI-XI de la figure 4.

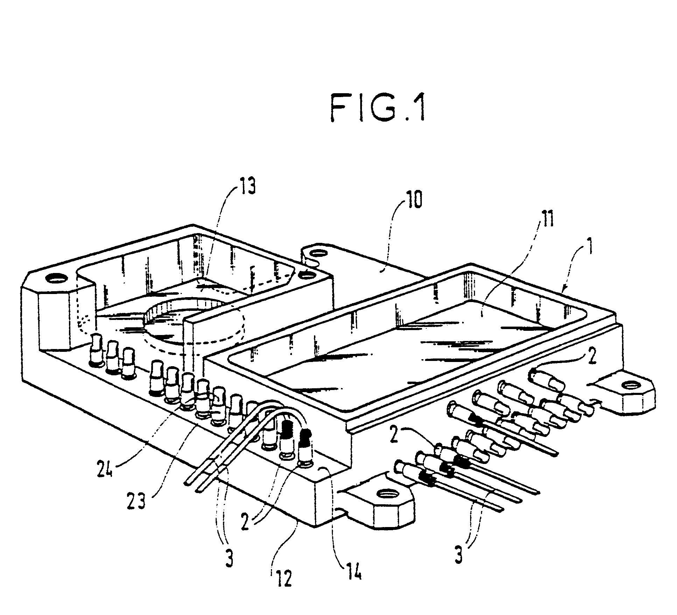

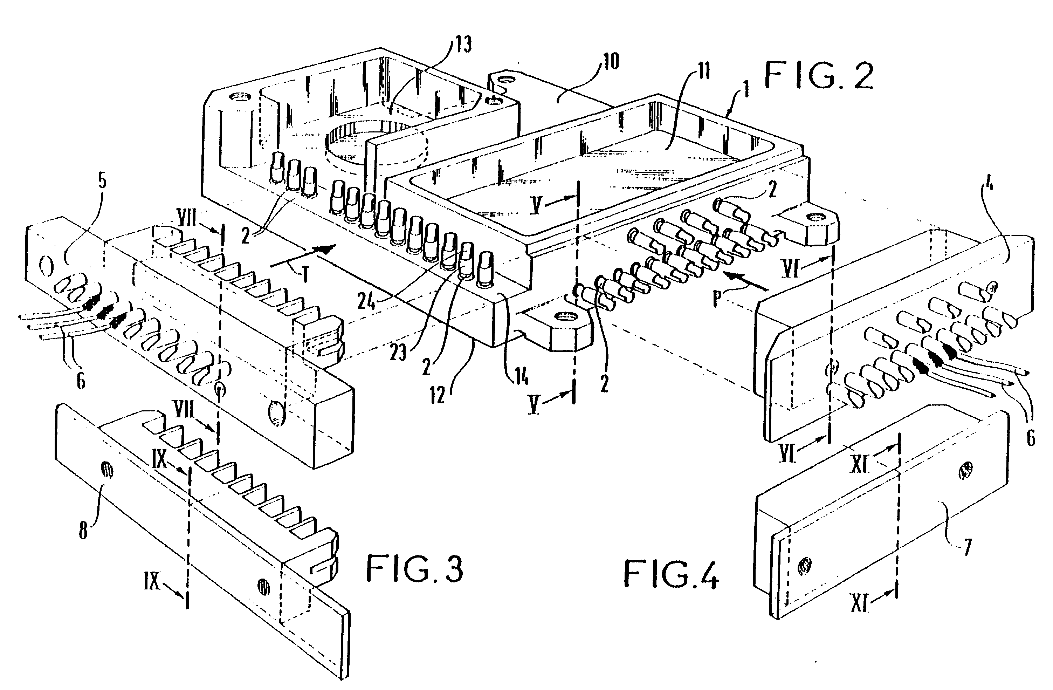

Dans les figures 1 et 2, on a illustré un boîtier métallique pour circuit hybride, désigné sous la référence générale 1. Ce boîtier, non encore fermé hermétiquement, présente dans l'exemple choisi plusieurs compartiments indépendants 11, 12 et 13 délimités recto-verso sur une cloison médiane 10. Ce boîtier 1 est équipé de rangées de traversées électriques désignées sous la référence générale 2, isolées et scellées individuellement dans l'épaisseur de ses parois qu'elles traversent de part en part en présentant alors chacune une extrémité extérieure au boîtier, et une extrémité intérieure à l'un des compartiments, ici 11 et 12, devant recevoir un circuit hybride.

Ces traversées 2, destinées à assurer le raccordement de circuits extérieurs aux circuits hybrides qui seront logés dans les compartiments 11 et 12, sont agencées pour permettre, à volonté, un raccordement fixe ou un raccordement amovible entre circuits hybrides et circuits extérieurs. Ainsi qu'il apparaît dans la figure 1, l'extrémité extérieure au boîtier de chacune des traversées 2 est adaptée pour autoriser l'engagement d'un conducteur étamé 3 et une soudure directe classique à l'étain-plomb. Comme représenté dans la figure 2, ces mêmes traversées 2 autorisent également un raccordement amovible, temporaire ou permanent au moyen de connecteurs complémentaires spécifiques 4 et 5 eux-mêmes reliés par des conducteurs soudés tels que 6 à des circuits extérieurs.

Ces connecteurs adaptés selon les variantes illustrées dans les figures 3 et 4 et désignées alors sous les références 7 et 8 respectivement permettront d'assurer une mise des circuits hybrides à la masse du boîtier les renfermant.

Ces traversées 2 adaptées aux modes de raccordement par soudure directe de conducteurs ou par connecteurs, ainsi que ces connecteurs complémentaires sont décrits ci-après de manière détaillée en se référant aux figures 1 à 4 et plus particulièrement aux figures suivantes considérées successivement.

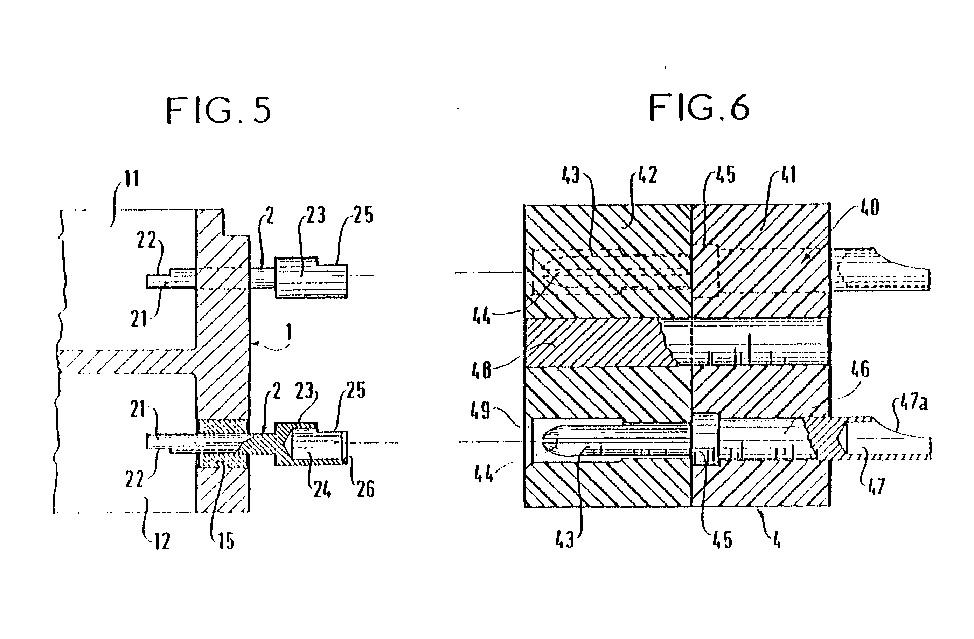

Dans la figure 5, qui est une coupe partielle selon la ligne V-V de la figure 2, on voit deux traversées 2, l'une coupée et l'autre non, appartenant à l'une et l'autre des deux rangées de traversées montées sur l'une des parois latérales du boîtier 1 qu'elles traversent de part en part pour déboucher à l'intérieur des deux compartiments 11 et 12 respectivement.

Ces traversées se présentent sous la forme générale d'une broche cylindrique et sont individuellement isolées et scellées de manière hermétique dans la paroi du boîtier 1 par une perle de verre 15. L'extrémité 21 de chaque traversée 2, interne au boîtier, présente avantageusement un méplat 22 pour permettre une soudure aisée, par ultrason ou thermo-compression d'un fil relié au circuit hybride (non représenté) qui sera logé dans le compartiment correspondant.

L'extrémité de chaque traversée 2, externe au boîtier, forme une tête terminale cylindrique 23, de diamètre supérieur à celui des autres parties de la broche. Cette tête 23 est pourvue d'un canal intérieur 24, d'axe aligné sur celui de la broche, ainsi que d'une lumière 25, débouchant dans ledit canal, pratiquée sur sa périphérie sur une partie de la longueur du canal et ouverte sur sa face frontale.

A l'extrémité de la tête 23 la surface interne, à l'opposé de la lumière 25 forme un chanfrein 26 facilitant l'insertion d'un conducteur à raccorder dans la tête 23.

La tête terminale 23 ne correspond pas à la longueur totale de l'extrémité externe au boîtier des traversées : l'épaulement qu'elle définit sur le corps de la traversée est écarté de la paroi du boîtier. Cet écartement est prévu pour prévenir toute remontée intempestive et néfaste de verre jusqu'à l'épaulement formé par la tête qui rendrait plus fragile le maintien des traversées.

Le matériau de ces traversées sera choisi en un alliage compatible avec le coefficient de dilatation thermique du verre ; il sera préférentiellement choisi en un alliage de fer, nickel et cobalt, et recevra un traitement de surface pour obtenir un scellement fiable des traversées.

Dans une réalisation spécifique, le corps cylindrique des traversées fait environ 0,8 mm de diamètre, la tête terminale environ 1,6 mm de diamètre et une longueur de 2,8 mm, la lumière est d'environ 1 mm de longueur, et le canal intérieur d'environ 1,2 mm de diamètre. Dans ces conditions l'écartement minimal entre la tête terminale et la paroi du boîtier est de l'ordre de 1 mm.

En regard des figures 1 et 5, on voit que les traversées selon l'invention présentent de nombreux avantages parmi lesquels on cite :

— le raccordement possible de conducteurs étamés 3 (figure 1) par soudure directe, ceci sans risque de bavure de la soudure sur la paroi du boîtier, donc sans risque de court-circuit, du fait de la présence du canal 24,

— la fiabilité de la soudure effectuée du fait de la présence de la lumière 25 qui crée un bon accès pour ces conducteurs et permet un bon dégazage de la soudure,

— la possibilité d'adopter des traversées à extrémité externe au boîtier de longueur très réduite et la possibilité d'adopter une disposition parallèle ou transversale des traversées par rapport aux parois latérales du boîtier, au gré des décrochements tels que 14 qu'elles peuvent présenter, autorisant toujours une soudure de conducteurs mais ne conduisant qu'à un encombrement minimal sur le boîtier tout en garantissant une excellente tenue du raccordement envers les chocs mécaniques ou thermiques ou envers les vibrations.

Ces mêmes traversées adaptées à une soudure de conducteurs sont, sans modification, parfaitement adaptées à un raccordement par connecteur à engagement effectué parallèlement ou transversalement aux traversées.

Dans la figure 6 on a illustré en coupe le connecteur 4 apparaissant dans la figure 2 permettant de réaliser une connexion amovible sur les traversées 2 montées sur l'une des parois du boîtier, par engagement du connecteur parallèlement à la direction des traversées, ainsi qu'illustré par la flèche P de cette figure 2.

En correspondance avec la disposition des traversées en deux rangées, le connecteur 4 comporte deux rangées analogues de broches conductrices 40 maintenues dans un support isolant 41-42 et adaptées pour venir se raccorder individuellement dans les traversées.

Ainsi chacune des broches 40, de forme cylindrique comporte une première portion terminale 43 de diamètre sensiblement égal à celui du canal de la tête terminale des traversées, présentant une fente longitudinale 44 la divisant en deux branches identiques à effet élastique. Une partie, au moins, de cette première portion terminale 43 constitue la partie mâle, avantageusement à bout arrondi, s'engageant dans la tête terminale des traversées.

En variante, non représentée, cette portion terminale peut être fendue en étoile ou en croix pour présenter alors trois ou quatre branches de contact à effet élastique.

La portion intermédiaire de chacune des broches présente un épaulement 45 pour leur maintien individuel dans le support 41-42, évitant tout glissement de la broche dans le corps du connecteur, formé par ce support.

Une deuxième portion terminale 46, opposée à la première, a son extrémité usinée pour permettre le raccordement aisé d'un conducteur électrique par soudure. Cette extrémité présente un biseau tronqué 47a et une échancrure interne 47.

Les broches de ce connecteur seront en un alliage, tel qu'un alliage à base de cuivre présentant une très bonne conductibilité, facilement usinable et de bonnes propriétés d'élasticité demeurant stables dans la gamme de température d'utilisation (— 55 °C à + 125 °C) sans nécessiter un quelconque traitement thermique après usinage, ceci favorisant le contrôle des forces de contact des branches.

Ces broches reçoivent en outre, en vue de leur protection, un traitement de surface consistant par exemple en un dépôt par recharge électrolytique d'environ 4 microns de nickel et 2,5 microns d'or, effectué avant le calibrage des forces de contact des broches dans les têtes des traversées.

Le réglage de ces forces de contact est fait en écartant les branches de la première portion terminale 43 et en faisant glisser dans la fente, une lame en coin, ceci sur une longueur donnée et dans les conditions de force de contact souhaitée. Le contrôle de la force est obtenu au moyen de masselottes extérieures agissant par gravité.

Ces broches individuelles sont maintenues dans leur support formé de deux pièces individuelles 41 et 42, isolantes, assemblées l'une à l'autre au moyen de vis ou de goupilles emmanchées à force telles que 48. Ces pièces 41 et 42 de support sont percées de part en part de manière correspondante à la disposition souhaitée des broches en définissant entre elles le logement pour les épaulements 45. L'une des pièces, 42, reçoit les premières portions terminales fendues des broches respectives, qui y sont entièrement logées, ses perçages étant, sur la longueur de l'extrémité externe des traversées qu'ils reçoivent, de diamètre légèrement supérieur à celui de la tête terminale qui s'y logera en butée et se terminant en des orifices 49, évasés sur la face de la pièce 42, dans lesquels sont très librement logés les bouts arrondis des broches, légèrement en retrait sur la face de la pièce 42 ou l'affleurant.

L'autre pièce 41 reçoit les épaulements 45 et les deuxièmes portions terminales des broches, ses perçages laissant un jeu latéral aux broches pour que le flottement résultant vienne compenser les imprécisions de positionnement des broches en regard des traversées. Les extrémités des broches débordent de cette pièce 41 pour y permettre la soudure aisée de conducteurs individuels.

En variante, non illustrée, les épaulements 45 pourront être pourvus d'un méplat ou pourront présenter un profilé sans symétrie de révolution pour obtenir alors un blocage en rotation des broches dans leur support.

Le support 41-42 des broches est réalisé en polycarbonate ou matériau isolant équivalent présentant une bonne tenue mécanique et thermique. Il peut être obtenu par moulage des deux pièces 41 et 42 indépendamment, ou même moulage d'une pièce unique se substituant alors aux deux pièces précédentes en utilisant un matériau permettant l'insertion à force des broches dans leurs logements.

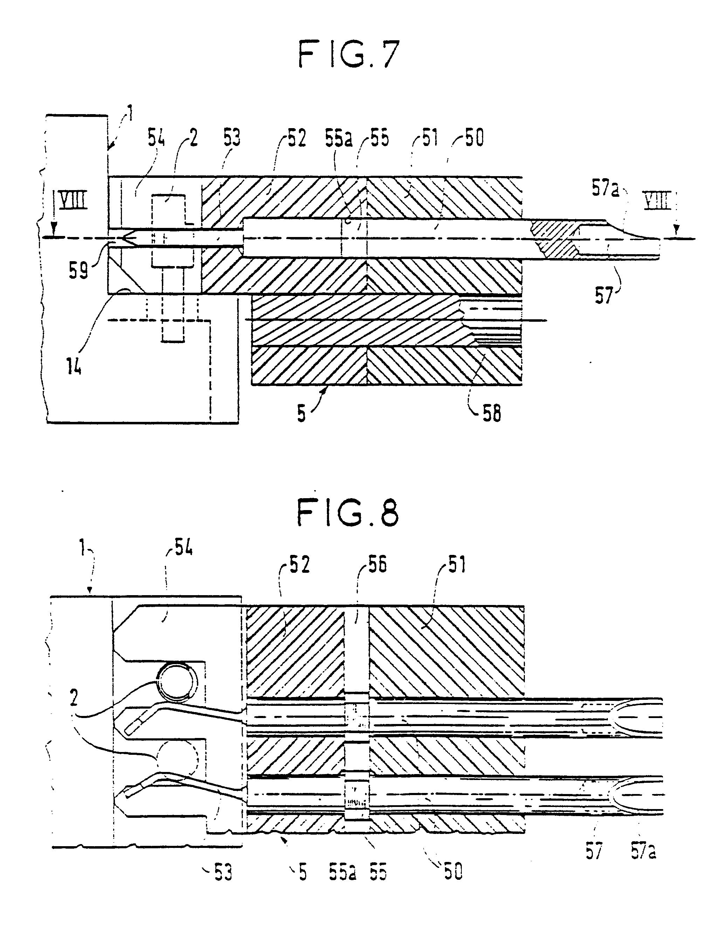

Dans les figures 7 et 8, on a illustré, selon deux coupes différentes, le connecteur 5 de la figure 2, associé aux traversées 2 montées sur le décrochement 14 de la paroi latérale du boîtier, réalisant une connexion amovible sur ces traversées par engagement du connecteur transversalement à la direction des traversées, ainsi qu'illustré par la flèche T dans cette figure 2.

Le connecteur 5 présente une rangée de broches conductrices 50, correspondant à tout ou partie de la rangée de traversées 2. disposées entre elles de même manière que les traversées concernées sur lesquelles elles viennent se raccorder individuellement. Ces broches 50 sont maintenues dans un support isolant formé de deux pièces 51 et 52 assemblées l'une à l'autre.

Les broches 50 de forme générale cylindrique ont des premières portions terminales 53 mises en forme de profil rigide cambré, de section rectangulaire, ce profil étant cambré sensiblement en arc prenant appui sur l'axe de la broche et venant sensiblement tangenter l'enveloppe cylindrique définie par le corps de la broche. Elles présentent aussi, sur une portion intermédiaire de leur corps cylindrique, un épaulement 55 sur lequel sont formés deux méplats opposés 55a, pour assurer leur maintien sans rotation possible dans les pièces de support 51 et 52. Enfin, leurs portions terminales, opposées à celles en forme du profil rigide cambré, qui seront extérieures aux pièces de support, ont une échancrure interne 57 et sont usinées en biseau tronqué 57a, pour le raccordement aisé d'un conducteur extérieur 6 (figure 2).

L'une des pièces de support, ici la pièce 52, se présente sous la forme générale d'un peigne dont la denture 54 est engageable entre les traversées 2 correspondantes. Cette pièce 52 présente, ici, sous la denture 54 dont les dents s'insèrent entre les traversées successives un décrochement complémentaire au décrochement 14 sur la paroi du boîtier 1 de sorte que la denture se trouve guidée au cours de son engagement dans les traversées, en la glissant sur la largeur du décrochement 14.

Les pièces de support 51 et 52 sont toutes deux percées de part en part pour définir les logements convenables des broches 50 lors de leur assemblage par vis ou goupilles emmanchées à force, telles que 58.

Dans la pièce 51, ces perçages sont cylindriques et sensiblement de même diamètre que le corps cylindrique des broches, ils reçoivent les portions de broches comprises entre leurs épaulements 55 et leurs parties terminales à échancrure 57 qui demeurent libres extérieurement. Dans la pièce 52, ces perçages sont également cylindriques et débouchent du côté de la denture 54 au fond d'une rainure 59 fendant longitudinalement la denture 54. Cette pièce 52 reçoit les portions de broches avec leurs épaulements 55 et comporte à cet effet, dans sa face opposée à la denture 54, deux rainures longitudinales 56, de part et d'autre de la série de perçages cylindriques, ouvertes dans ces perçages dans lesquelles viennent se loger les épaulements 55 des broches. Cette pièce 52 reçoit dans les perçages cylindriques le corps des broches compris entre l'épaulement 55 et la portion terminale en fil rigide cambré, cette portion en fil rigide cambré venant déboucher au fond de la rainure 59, sensiblement au niveau du plan médian de la dent pour s'étendre dans l'entredent correspondant et se terminer à nouveau sensiblement dans le plan médian de la dent, c'est-à-dire entre les deux parties de dents obtenues par la rainure 59.

On notera en regard des figures 7 et 8, que ce connecteur assure un raccordement entre traversées 2 et broches 50 par contact des profils rigides cambrés 53 des broches s'étendant dans les entredents successifs et constituant ainsi des contacts élastiques sur la périphérie des têtes terminales des traversées 2. Ces contacts ainsi réalisés sont améliorés par la section rectangulaire donnée aux fils et appliquée contre les têtes des traversées.

Dans la pratique les broches sont réalisées en bronze au béryllium état demi écroui (Cu Be 1,9 Pb), puis trempées entre 315 et 320 °C et refroidies sous atmosphère neutre (Azote-Hydrogène) à température ambiante. Les pièces de support 51 et 52 sont quant à elles réalisées en matériau analogue à celui des pièces de support des broches du connecteur 4.

Ces deux types de connecteurs 4 et 5, à engagement parallèlement ou transversalement dans la ou les rangées de traversées conduisent à des raccordements fiables et rapides sur les traversées 2 de boîtiers microélectroniques hybrides. Ils sont compatibles à des montages et démontages fréquents, tels que ceux effectués temporairement au cours des opérations de fabrication, de mise au point et de tests des circuits électroniques telles que, par exemple, certains essais en vibrations ou en chocs alors que ces circuits sont alimentés à partir de circuits extérieurs par leurs signaux de commande.

Ces mêmes connecteurs demeurent également compatibles avec une utilisation permanente lors du fonctionnement normal des boîtiers microélectroniques hybrides.

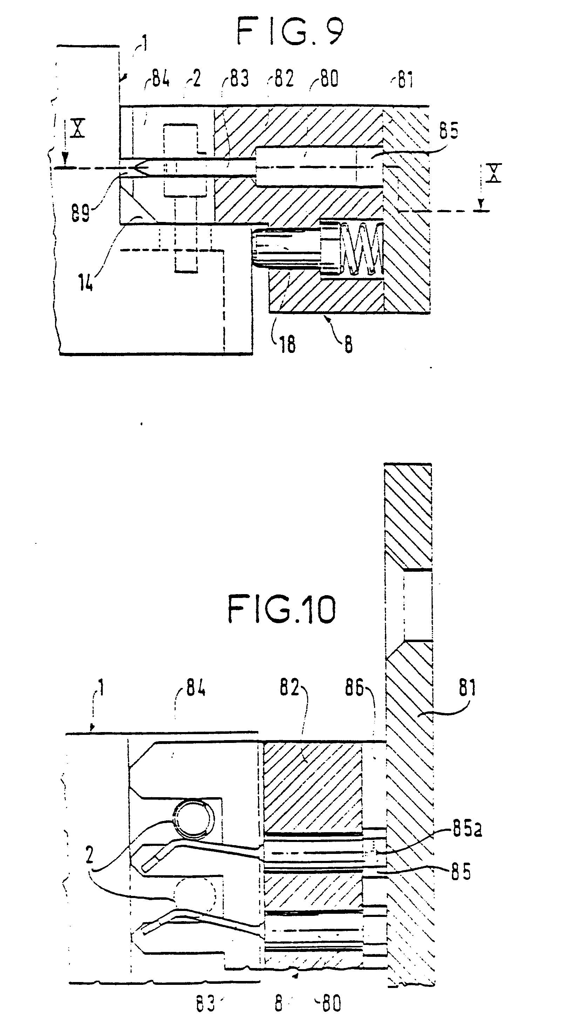

Les connecteurs 8 et 7 illustrés dans les figures 9-10 et 11 sont directement déduits des réalisations des connecteurs 5 et 4 précédents ; ils sont prévus pour mettre à la masse les traversées 2 sur lesquelles ils s'adaptent, en particulier lors d'opérations d'interconnexions des circuits électroniques avec les traversées, ou de fermeture électrique du boîtier.

Le connecteur 8 illustré dans la figure 3 et plus particulièrement dans les figures 9 et 10 est issu d'adaptations du connecteur 5 précédent (figures 7 et 8) ; les références qui lui sont affectées sont donc déduites de celles affectées aux éléments comparables du connecteur 5, en substituant au chiffre précédent 5 des dizaines le chiffre 8 propre à connecteur de court-circuit, et seules les adaptations conduisant à ce connecteur 8 sont données ci-après.

Dans ce connecteur 8, les broches 80 se terminent, à l'opposé des profils rigides cambrés, par les épaulements 85, un raccordement de conducteurs extérieurs n'étant plus nécessaire dans le cadre de la fonction de ce connecteur, et sont maintenues par deux pièces de support 81 et 82 métalliques assurant un contact permanent entre les broches et le corps du connecteur.

De plus la pièce de support 81 porte, sous la denture 84, un picot conducteur 18, monté de manière élastique dans sa face venant en regard du boîtier 1, ici par montage de la tête du picot et d'une liaison à ressort en butée dans le support 82 et contre le support 81 obturant leur logement.

Dans ces conditions, lors des raccordements du connecteur 8 sur la rangée de traversées 2 qui lui correspond, le picot 18 constitue une prise de masse du boîtier 1 avec lequel il est en contact, qui transmise aux broches par les pièces métalliques 81 et 82 est appliquée à l'ensemble des traversées concernées.

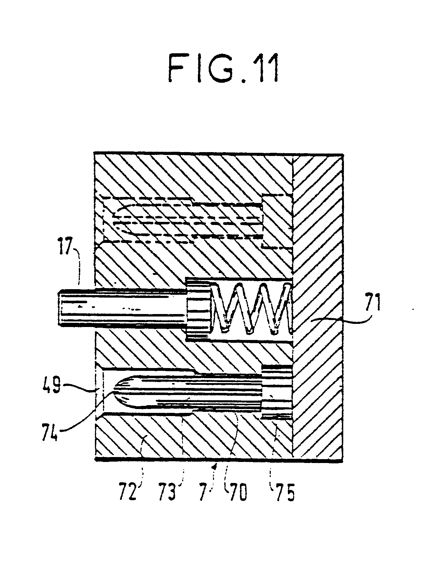

Le connecteur 7 illustré dans la figure 4 et plus précisément dans la figure 11 est issu d'adaptations du connecteur 4 précédent (figure 6). Les références qui lui sont affectées sont déduites de celles affectées au connecteur 4, selon la règle adoptée en ce qui concerne les connecteurs 8 et 5 et seules les adaptations conduisant au connecteur 7 sont indiquées ci-après.

Dans ce connecteur 7, les broches 70 sont limitées à leur portion terminale 73 présentant une fente longitudinale 74 et à l'épaulement adjacent 75, leur raccordement à des conducteurs extérieurs n'étant pas requis.

Elles sont logées dans la pièce de support 72 et maintenues bloquées par la pièce de support 71, toutes deux métalliques, assurant un contact permanent entre les broches du connecteur. De plus ce connecteur 7 est équipé d'un picot conducteur 17, parallèle aux broches 70 mais en relief sur sa face engageable dans les traversées, monté de manière élastique dans la pièce de support 72 par montage de sa tête et d'un ressort en butée dans un perçage de la pièce 72 obturé par la pièce 71. Ainsi lors du raccordement du connecteur 7 sur les traversées qui lui correspondent sur le boîtier, ces traversées sont mises à la masse du boîtier par report de cette masse sur le connecteur 7.

## Revendications

1. Traversée électrique de boîtier de circuit hybride, ayant la forme générale d'une broche cylindrique, montée fixée dans l'épaisseur du boîtier au moyen d'une perle de verre en ayant ses extrémités débordant intérieurement et extérieurement, pour sa connexion au circuit hybride et à un circuit extérieur, respectivement, caractérisée en ce que l'extrémité de ladite traversée (A), externe au boîtier, comporte une tête terminale cylindrique (23) distante de la paroi du boîtier (1), de diamètre supérieur à celui du corps de la traversée et pourvue d'un canal intérieur axial (24), de manière à y permettre, à volonté, le raccordement par soudure d'un conducteur extérieur (3) ou le raccordement de l'une des broches conductrices d'un connecteur (4, 5).

2. Traversée selon la revendication 1, caractérisée par le fait que ladite tête (23) présente une lumière (25) pratiquée sur sa périphérie et débouchant dans ledit canal (24).

3. Traversée selon la revendication 2, caractérisée par le fait que ladite lumière (25) est oblongue et ouverte sur la face frontale de ladite tête (23).

4. Association de traversées électriques selon l'une des revendications 1 à 3, montées en au moins une rangée sur une même paroi de boîtier de circuit hybride, et d'un connecteur complémentaire, caractérisée par le fait que le connecteur complémentaire comporte une pluralité de broches conductrices cylindriques (40, 70) fendues (44, 74) longitudinalement, chacune sur la longueur d'une première portion terminale de diamètre sensiblement égal à celui du canal de la tête terminale (23) de chaque traversée (2), et maintenues, en correspondance de dispositions relatives avec celles des traversées sur ladite paroi du boîtier, dans un support (41-42, 71-72) sur une face plane duquel affleurent sensiblement les extrémités des premières portions terminales fendues, logées respectivement dans des orifices circulaires (49, 79) de diamètre légèrement supérieur à celui de la tête terminale (23) de chaque traversée (2).

5. Association selon la revendication 4, caractérisée par le fait que lesdites broches fendues présentent au-delà de leurs premières portions terminales respectives une surface étagée (45, 75) et en ce que ledit support (41-42, 71-72) comporte une pluralité de logements pour les broches respectives présentant chacun également une surface étagée complémentaire de celle de chacune des broches pour le blocage longitudinal de la broche (40, 70) qu'il reçoit.

6. Association selon l'une des revendications 4 et 5, caractérisée par le fait que ledit support est constitué par deux pièces isolantes (41-42) sensiblement parallélépipédiques assemblées l'une à l'autre et percées l'une et l'autre de trous définissant les logements des broches respectives (40) dans chacun desquels la broche reçue est bloquée longitudinalement et a sa première portion terminale (43) librement logée dans l'une desdites pièces.

7. Association selon l'une des revendications 4 et 5, caractérisée par le fait que ledit support (71-72) est en métal pour assurer une continuité électrique entre lesdites broches (70) et porte, en outre, un picot conducteur (17) débordant sur ladite face plane du support, d'une longueur sensiblement égale à celle de l'extrémité externe au boîtier de chacune desdites traversées (2), pour assurer une prise de la masse électrique du boîtier et son report sur lesdites broches (70).

8. Association de traversées électriques selon l'une des revendications 1 à 3, montées en une rangée sur une même paroi de boîtier de circuit hybride, et d'un connecteur complémentaire caractérisée par le fait que le connecteur complémentaire comporte une pluralité de broches conductrices (50, 80) fixées dans un support (51-52, 81-82) en forme de peigne dont la denture (54, 84) engageable entre les traversées (2) présente une fente longitudinale (59, 89) dans laquelle débouchent les portions terminales des broches chacune formée d'un profil rigide (53, 83) cambré vers l'entredent, constituant ainsi des contacts élastiques sur la périphérie des traversées (2) lors de l'engagement de la denture dans la rangée de traversée.

9. Association selon la revendication 8, caractérisée par le fait que les extrémités libres des profils rigides cambrés sont protégées dans l'épaisseur des dents respectives de la denture (54, 84) du support.

10. Association selon l'une des revendications 8 et 9, caractérisée par le fait que lesdits profils rigides cambrés (53, 83) sont de section rectangu-

laire.

11. Association selon l'une des revendications 8 à 10, caractérisé par le fait que lesdites broches (50, 80) présentent, au-delà de leur première portion terminale en forme de profil cambré, un épaulement (55, 85) à méplats (55a, 85a) assurant leur maintien sans rotation possible dans leur support.

12. Association selon la revendication 11, caractérisée par le fait que ledit support (81-82) est en métal et porte, en outre, un picot conducteur (18) monté élastiquement dans son épaisseur et débordant sur l'une de ses faces pour constituer une prise de masse du boîtier lorsque le connecteur est engagé dans la rangée de traversées qui lui sont affectées et assurer un report de cette masse sur les traversées par l'intermédiaire du connecteur.

**Claims**

1. Electric bushing of a hybrid circuit housing, having the general shape of a cylindrical pin, fixedly mounted in the thickness of the housing by means of a glass bead, having its ends projecting inside and outside, for its connection to the hybrid circuit and to an external circuit, respectively, characterized in that the end of the bushing (2) outside of the housing comprises a cylindrical end head (23) remote from the wall of the housing (1) and having a diameter exceeding that of the body of the bushing, and provided with an inner axial channel (24), in a manner to permit, at will, the connection of an outer conductor (3) by soldering or the connection of any of the conductive pins of a connector (4, 5).

2. Bushing according to claim 1, characterized by the fact that said head (23) has an opening (25) formed on its periphery and ending in said channel (24).

3. Bushing according to claim 2, characterized by the fact that said opening (25) is oblong and open on the front face of said head (23).

4. Association of electric bushings according to any of claims 1 to 3, mounted in at least one row on the same wall of the hybrid circuit housing, with a complementary connector, characterized by the fact that the complementary connector comprises a plurality of cylindrical conductive pins (40, 70) which are longitudinally slit (44, 74), each across the length of a first terminal portion having a diameter substantially equal to that of the channel of the end head (23) of each bushing (2), and maintained, in relative positional correspondence with that of the bushings on said housing wall, in a carrier (41-42, 71-72) to one plane face of which the ends of the first slit terminal portions substantially extend, being respectively accommodated in circular orifices (49, 79) having diameters slightly exceeding that of the terminal head (23) of each bushing (2).

5. Association according to claim 4, characterized by the fact that said slit pins have a stepped surface (45, 75) beyond their respective end portions, and in that said carrier (41-42, 71-72) comprises a plurality of accommodations for the respective pins, each likewise having a stepped surface, complementary of that of each of the pins, for the longitudinal blocking of the pin (40, 70) received thereby.

6. Association according to any of claims 4 and 5, characterized by the fact that said carrier is constituted by two insulating members (41-42) of substantially parallelepipedic shape and assembled with each other and pierced one and the other with holes defining the accommodations of the respective pins (40) in each of which the received pin is longitudinally blocked having its first terminal portion (43) freely accommodated in one of said members.

7. Association according to any of claims 4 and 5, characterized by the fact that said carrier (71-72) is of metal to ensure an electric continuity between said pins (70), and further carries a conductive peg (17) projecting on said plane face of the carrier, across a length substantially equal to that of the end of each of said bushings (2) which is outside of the housing, to ensure an electric ground connection of the housing and its transfer to said pins (70).

8. Association of electric bushings according to any of claims 1 to 3, mounted in a row on the same wall of the hybrid circuit housing, with a complementary connector, characterized by the fact that the complementary connector comprises a plurality of conductive pins (50, 80) fixed in a comb-shaped carrier (51-52, 81-82) the toothed portion (54, 84) of which is engageable between the bushing (2) and has a longitudinal slit (59, 89) whereinto the terminal portions of the pins extend which are each formed with a rigid profile (53, 83) arched towards the space between the teeth, thus forming resilient contacts on the periphery of the bushings (2) upon engagement of the toothed portion in the row of bushings.

9. Association according to claim 8, characterized by the fact that the free ends of the rigid arched profiles are protected in the thickness of the respective teeth of the toothed portion (54, 84) of the carrier.

10. Association according to any of claims 8 and 9, characterized by the fact that said rigid arched profiles (53, 83) have rectangular sections.

11. Association according to any of claims 8 to 10, characterized by the fact that said pins (50, 80) are provided beyond their terminal portions shaped according to an arched profile with a shoulder (55, 85) having flats (55a, 85a) ensuring their maintenance in the carrier without any possible rotation.

12. Association according to claim 11, characterized by the fact that said carrier (81-82) is of metal and further carries a conductive peg (18) resiliently mounted in its thickness and projecting on one of its faces to constitute a ground connection of the housing when the connector is engaged in the row of bushings associated thereto and to ensure a transfer of this ground to the bushings through the connector.

**Patentansprüche**

1. Elektrische Gehäusedurchquerung einer Hybridschaltung, von der allgemeinen Form eines zylindrischen Stiftes, der in der Wandstärke des Gehäuses fest mittels einer Glasperle montiert ist, wobei seine Enden innenseitig und außenseitig überstehen, zum Anschließen an die Hybridschaltung bzw. an einen äußeren Kreis, dadurch gekennzeichnet, daß das Ende der genannten Durchquerung (2), welches außerhalb des Gehäuses liegt, einen zylindrischen Endkopf (23) umfaßt, welcher von der Wandung des Gehäuses (1) entfernt ist, dessen Durchmesser größer als der des Körpers der Durchquerung ist und der mit einem innenliegenden awialen Kanal (24) versehen ist, so daß dort beliebig das Anschließen eines Außenleiters (3) durch Anlöten oder das Anschließen einer der Leiterstifte eines Verbinders (4, 5) ermöglicht wird.

2. Durchquerung nach Anspruch 1, dadurch gekennzeichnet, daß der genannte Kopf (23) einen Ausschnitt (25) aufweist, der an seinem Umfang angebracht ist und in den genannten Kanal (24) einmündet.

3. Durchquerung nach Anspruch 2, dadurch gekennzeichnet, daß der genannte Ausschnitt (25) gestreckt und auf der Stirnseite des genannten Kopfes (23) offen ist.

4. Zuordnung von elektrischen Durchquerungen nach einem der Ansprüche 1 bis 3, welche in wenigstens einer Reihe auf derselben Wand des Gehäuses der Hybridschaltung angeordnet sind, zu einem komplementären Verbinder, dadurch gekennzeichnet, daß der komplementäre Verbinder mehrere zylindrische Leiterstifte (40, 70) aufweist, die in Längsrichtung geschlitzt (44, 74) sind, jeweils über die Länge eines ersten Endteiles mit einem Durchmesser, der im wesentlichen gleich dem des Kanals des Endkopfes (23) jeder Durchquerung (2) ist, und welche in relativer Entsprechung zur Anordnung der Durchquerungen an der Gehäusewandung in einem Träger (41-42, 71-72) gehalten werden, auf dessen einer ebenen Fläche die Enden der ersten geschlitzten Endteile auslaufen, die jeweils in kreisrunden Öffnungen (49, 79) aufgenommen sind, deren Durchmesser etwas größer als der des Endkopfes (23) jeder Durchquerung (2) ist.

5. Zuordnung nach Anspruch 4, dadurch gekennzeichnet, daß die genannten geschlitzten Stifte jenseits von ihren jeweiligen Endteilen eine gestufte Oberfläche (45, 75) aufweisen und daß der genannte Träger (41-42, 71-72) mehrere Aufnahmen für die jeweiligen Stifte aufweist, die jeweils ebenfalls eine gestufte Oberfläche aufweisen, die komplementär zu der jedes Stiftes ist, zur Blockierung des davon aufgenommenen Stiftes (40, 70) in Längsrichtung.

6. Zuordnung nach einem der Ansprüche 4 und 5, dadurch gekennzeichnet, daß der genannte Träger durch zwei Isolierteile (41-42) gebildet ist, die im wesentlichen quaderförmig und aneinandergesetzt sowie das eine wie das andere mit Löchern durchbohrt sind, welche Aufnahmen für die entsprechenden Stifte (40) bilden, worin jeweils der aufgenommene Stift in Längsrichtung blockiert ist und sein Endteil (43) frei in einem der Teile aufgenommen ist.

7. Zuordnung nach einem der Ansprüche 4 und 5, dadurch gekennzeichnet, daß der genannte Träger (71-72) aus Metall besteht, um eine elektrische Durchgängigkeit zwischen den genannten Stiften (79) zu gewährleisten, und ferner einen Leiterzapfen (17) trägt, welcher über die genannte ebene Fläche des Trägers hinaussteht, auf einer Länge, die im wesentlichen gleich der des äußeren Endes des Gehäuses jeder der genannten Durchquerungen (2) ist, um eine elektrische Masseverbindung des Gehäuses und deren Übertragung auf die genannten Stifte (70) zu gewährleisten.

8. Zuordnung von elektrischen Durchquerungen nach einem der Ansprüche 1 bis 3, die in einer Reihe auf derselben Gehäusewandung der Hybridschaltung angeordnet sind, mit einem komplementären Verbinder, dadurch gekennzeichnet, daß der komplementäre Verbinder eine Mehrzahl von Leiterstiften (50, 80) aufweist, welche in einem kammförmigen Träger (51-52, 81-82) befestigt sind, dessen zwischen die Durchquerungen (2) einsetzbare Zinkenanordnung (54, 84) einen Längsschlitz (59, 89) aufweist, in welchen die Endteile der Stifte einmünden, die jeweils durch ein starres Profil (53, 83) gebildet sind, welches zu dem Zwischenraum zwischen dem Zinken hin gewölbt ist, so daß elastische Kontakte am Umfang der Durchquerungen (2) gebildet werden, wenn die Zinkenanordnung in die Reihe von Durchquerungen eingesetzt wird.

9. Zuordnung nach Anspruch 8, dadurch gekennzeichnet, daß die freien Enden der gewölbten starren Profile in der Dicke der jeweiligen Zinken der Zinkenanordnung (54, 84) des Trägers geschützt sind.

10. Zuordnung nach Anspruch 8 oder 9, dadurch gekennzeichnet, daß die genannten starren gewölbten Profile (53, 83) eine rechtwinklige Querschnittsform haben.

11. Zuordnung nach einem der Ansprüche 8 bis 10, dadurch gekennzeichnet, daß die genannten Stifte (50, 80) jenseits von ihrem ersten Endteil, das eine gewölbte Profilform aufweist, eine Schulter (55, 85) mit Abflachungen (55a, 85a) aufweisen, welche ihren drehfesten Halt in ihrem Träger gewährleisten.

12. Zuordnung nach Anspruch 11, dadurch gekennzeichnet, daß der genannte Träger (81-82) aus Metall besteht und ferner einen Leiterzapfen (18) trägt, welcher elastisch in seiner Wandstärke angebracht ist und auf einer seiner Flächen übersteht, um eine Masseverbindung des Gehäuses zu bilden, wenn der Verbinder in die ihm zugeordnete Reihe von Durchquerungen eingesetzt wird, um einen Übergang dieser Masse auf die Durchquerungen über den Verbinder zu gewährleisten.

# FIG.1

FIG. 2

FIG. 3

FIG. 4

0 087 159

# FIG.5

# FIG.6

0 087 159

# FIG.7

# FIG.8

# FIG.9

# FIG.10

# FIG.11